# EUROPÄISCHE PATENTSCHRIFT

(11) **EP 2 048 748 B1**
(45) Veröffentlichungstag und Bekanntmachung des Hinweises auf die Patenterteilung: **03.11.2010**
(21) Anmeldenummer: 08165998.9
(22) Anmeldetag: 07.10.2008
(51) Int. Cl.: H01R 29/00, B60D 1/64

(54) **Vorrichtung zum Anschluss an eine Anhängersteckdose eines Kraftfahrzeugs**
Device to be connected to a trailer outlet socket of a motor vehicle
Dispositif de raccordement sur une connexion de remorque d'un véhicule automobile

(30) Priorität: 09.10.2007 DE 102007048378
(43) Veröffentlichungstag der Anmeldung: 15.04.2009
(73) Patentinhaber: Rüttgerodt, Werner, 34355 Staufenberg (DE)
(72) Erfinder: Rüttgerodt, Werner, 34355 Staufenberg (DE)
(74) Vertreter: Rehberg Hüppe + Partner

(56) Entgegenhaltungen:
- DE-A1- 4 224 720
- DE-A1- 10 237 537
- DE-A1- 10 324 888
- DE-A1- 19 912 732
- US-A- 4 694 372
- US-A1- 2003 057 955
- US-B1- 6 222 446

## Beschreibung

### TECHNISCHES GEBIET DER ERFINDUNG

Die Erfindung bezieht sich auf eine Vorrichtung zum Anschluss an eine Anhängersteckdose eines Kraftfahrzeugs mit den Merkmalen des Oberbegriffs des unabhängigen Patentanspruchs 1.

Mit einer Anhängersteckdose wird hier die an einem Kraftfahrzeug vorgesehene Steckdose bezeichnet, die dazu dient, die Elektrik eines an das Kraftfahrzeug angehängten Anhängers mittels eines in die Steckdose passenden Steckers mit der Elektrik des Kraftfahrzeugs zu verbinden. Dies ist notwendig, um beispielsweise die Beleuchtung des Anhängers synchron zur Beleuchtung des Kraftfahrzeugs anzusteuern. Üblicherweise verfügt ein Anhänger überdies über keine eigene Stromversorgung.

Eine derartige Anhängersteckdose kann nicht nur zur Verbindung der Elektrik eines ein eigenes Fahrwerk aufweisenden Anhängers mit der Elektrik des Kraftfahrzeugs verwendet werden, sondern auch für Anbauten an das Kraftfahrzeug mit eigener Elektrik, wie beispielsweise für beleuchtete Fahrradträger.

Unter Kraftfahrzeugen sind hier sowohl PKW zu verstehen, bei denen eine 12 V Elektrik sowie 7- und 13-polige Anhängersteckdosen üblich sind, als auch LKW, bei denen eine 24 V Elektrik üblich ist und auch 15- sowie anderspolige Anhängersteckdosen vorkommen.

### STAND DER TECHNIK

Um die korrekte Verdrahtung einer Anhängersteckdose mit der Elektrik des jeweiligen Kraftfahrzeugs zu überprüfen, ist es möglich, einen Anhänger über die Steckdose anzuschließen und alle über die Steckdose laufenden Funktionen einzeln auszuprobieren, wobei die Funktion der Beleuchtung des Anhängers beobachtet wird. Da dies jedoch mühsam ist, sind Prüfvorrichtungen entwickelt worden, die die Elektrik eines typischen Anhängers nachbilden. Derartige Prüfvorrichtungen weisen dieselben verschiedenen Leuchtmittel auf, wie sie auf einem Anhänger vorgesehen sind. Entsprechend sind diese Prüfvorrichtungen sehr aufwändig.

Bei einer aus der DE 199 12 732 A1 bekannten Prüfvorrichtung mit den Merkmalen des Oberbegriffs des unabhängigen Patentanspruchs 1 sind keine Leuchtmittel vorgesehen, die eine einer realen Beleuchtung eines Anhängers entsprechende Leistungsaufnahme aufweisen. Stattdessen sind in der Vorrichtung verschiedene Lastwiderstände vorgesehen, die mit ihrer Leistungsaufnahme verschiedene Glühbirnen simulieren. Gleichzeitig zeigen Leuchtdioden, die ihrerseits nur eine geringe elektrische Leistung aufnehmen an, welche Lampe der Beleuchtung eines an die Anhängersteckdose angeschlossenen Anhängers leuchten würde. Diese Leuchtdioden werden jeweils über einen Transistor angesteuert. Als nachteilig bei der bekannten Prüfvorrichtung erweist sich, dass die Lastwiderstände kostspielig sind und in ihrer Verwendung erhebliche Wärme erzeugen, die mit großem Aufwand von jedem von Ihnen abgeführt werden muss, um eine Beschädigung oder gar Zerstörung der Prüfvorrichtung zu vermeiden. Zur Sicherheit gegenüber einer Überhitzung ist bei der aus der DE 199 12 732 A1 bekannten Prüfvorrichtung ein zusätzlicher temperaturabhängiger Widerstand im Massepfad vorgesehen.

Über den Inhalt der DE 199 12 732 A1 hinaus ist es bekannt, die Leuchtdioden nicht direkt an dem Stecker, sondern an einer über ein längeres Verbindungskabel mit dem Stecker der Prüfvorrichtung verbundenen Anzeigeeinheit vorzusehen, die es einer Person ermöglicht, im Kraftfahrzeug sitzend die einzelnen Funktionen, die über die Anhängersteckdose laufen, unter unmittelbarer Sichtbarkeit des Ergebnisses abzuprüfen.

Die Überwachungselektronik moderner Kraftfahrzeuge weist den Fahrer unter anderem auf das Ausfallen einzelner Leuchtmittel in der Kraftfahrzeugbeleuchtung hin. Ein solcher Ausfall wird fälschlicherweise vielfach auch dann angezeigt, wenn eine LED-Leuchte statt einer Leuchte mit Glühbirnen an einem Anhänger vorgesehen ist, die eine vergleichsweise niedrige Leistungsaufnahme aufweist. Zwar kann der Fahrer eines Kraftfahrzeugs ein derart falsches Signal hinnehmen. Er riskiert damit jedoch, dass er auf tatsächliche Ausfälle in der Beleuchtung keinen Hinweis erhält.

Moderne Kraftfahrzeuge sind vielfach mit einem sogenannten CAN (Controller Area Network)-Bus ausgestattet, über den auch Fehlermeldungen bzw. Bestätigungsmeldungen für korrekte Funktionen zu Teilen der Kraftfahrzeugelektrik übertragen werden können. Es gibt jedoch keinen einheitlichen Standard, welche der Leitungen einer Anhängersteckdose für eine mögliche CAN-Buskommunikation zwischen einem Kraftfahrzeug und einem daran angehängten Anhänger eingesetzt werden soll, wobei die elektrischen Signale der CAN-Buskommunikation auf diese Leitung, die ihre normale Funktion weiter erfüllt, aufmoduliert werden.

### AUFGABE DER ERFINDUNG

Der Erfindung liegt die Aufgabe zugrunde, eine Vorrichtung mit den Merkmalen des Oberbegriffs des Patentanspruchs 1 aufzuzeigen, die die oben geschilderten Nachteile der bekannten Prüfvorrichtung beseitigt.

### LÖSUNG

Erfindungsgemäß wird die Aufgabe durch eine Vorrichtung mit den Merkmalen des unabhängigen Patentanspruchs 1 gelöst. Die abhängigen Patentansprüche 2 bis 11 betreffen bevorzugte Ausführungsformen der neuen Vorrichtung.

### BESCHREIBUNG DER ERFINDUNG

Bei der neuen Vorrichtung weist die elektrische Schaltung einen spannungsabhängigen Widerstand zwischen zwei festen Polen des Steckers auf, der in Abhängigkeit von der Spannung an jeweils einem oder mehreren von verschiedenen anderen Polen des Steckers angesteuert wird. Der Widerstand simuliert damit je nach seiner Ansteuerung verschiedene, das heißt verschieden große Lasten. Dabei fließt der diesen Lasten entsprechende Strom zwar immer zwischen zwei festen Polen, d. h. nicht von dem jeweiligen anderen Pol, mit dem die simulierte Last angesteuert wird. Dies wird jedoch von der Elektrik des jeweiligen Kraftfahrzeugs nicht unterschieden. Diese bemerkt nur einen der jeweils angesteuerten Last entsprechenden zusätzlichen Verbrauch. Dabei kann der spannungsabhängige Widerstand auch so leistungsfähig dimensioniert sein, dass er mehr als eine Last auf einmal simulieren kann. Die elektrische Schaltung der neuen Vorrichtung kann aber auch so ausgebildet sein, dass der spannungsabhängige Widerstand immer nur mit der Spannung an einem Pol des Steckers angesteuert wird. Indem die elektrische Schaltung der neuen Vorrichtung in der Regel nur einen einzigen spannungsabhängigen Widerstand aufweist, werden nicht nur weniger Widerstände, über die ein Leistungsstrom fließt, als bislang benötigt, sondern es muss auch nur ein einziger Widerstand gekühlt werden.

Der spannungsabhängige Widerstand der elektrischen Schaltung kann ein Halbleiterwiderstand sein. Bevorzugt ist ein Feldeffekttransistor. Besonders gut geeignet ist ein MOSFET (Metal Oxide Semiconductor Field Effect Transistor). MOSFETs gibt es zu günstigen Kosten in der hier benötigten Leistungsklasse.

Der spannungsabhängige Widerstand der elektrischen Schaltung der neuen Vorrichtung kann thermisch mit einer Wärmesenke, insbesondere einem Kühlblech verbunden ist. Da nur ein einziger Widerstand zu kühlen ist, kann das Kühlblech vergleichsweise groß ausfallen, ohne dass hierdurch der Gesamtaufwand für die neue Vorrichtung wesentlich ansteigt.

Die elektrische Schaltung kann grundsätzlich so ausgebildet sein, dass sie die an dem jeweiligen Pol des Steckers anliegende Spannung direkt oder nur unter passier Spannungsanpassung zur Ansteuerung des spannungsabhängigen Widerstands verwendet. Bevorzugt ist es jedoch, wenn die elektrische Schaltung einen permanent mit Strom versorgten Mikroprozessor aufweist, der den spannungsabhängigen Widerstand ansteuert. Der Mikroprozessor weist dann typischerweise eine feste Programmierung für diese Ansteuerung auf. Je nach der Art des Steckers, mit dem die neue Vorrichtung ausgerüstet ist, kann diese Stromversorgung über Dauerplus- und Dauerminuspole des Steckers oder über einen willkürlich dauerhaft mit Spannung belegbaren Pol und einen Minuspol des Steckers erfolgen, zwischen die dann auch der spannungsabhängige Widerstand geschaltet ist. Alternativ kann die Vorrichtung mit einer Batterie zur Spannungsversorgung des Mikroprozessors ausgerüstet sein.

Konkret ist der spannungsabhängige Widerstand bei einem 7-poligen Stecker vorzugsweise zwischen einen Pol für Fahrtlicht und einen Pol für einen Minusleiter geschaltet. Es versteht sich, dass der spannungsabhängige Widerstand dabei so mit einer Grundsteuerspannung angesteuert werden muss, dass er die dem Fahrtlicht entsprechende Last immer zusätzlich zu jeder weiteren Last simuliert, die über einen der anderen Pole angesteuert wird. Bei einem 13-poligen Stecker ist der spannungsabhängige Widerstand hingegen vorzugsweise zwischen einen Pol für Dauerplus und einen Pol für einen Minusleiter, insbesondere einen Minusleiter für die zu überprüfenden Pole des Steckers geschaltet.

Zusätzlich kann die elektrische Schaltung der neuen Vorrichtung beim Anlegen der Spannung an den jeweiligen Pol des Steckers an mindestens den gleichen oder einen anderen Pol des Steckers ein Kommunikationssignal ausgeben, das angibt, dass die Last in Ordnung ist. Dies ist insbesondere dann von Interesse, wenn das jeweilige Kraftfahrzeug ein CAN-Bussystem aufweist. Dann kann das Kommunikationssignal auf einer an dem jeweiligen Pol anliegende Spannung aufmoduliert werden.

Angesichts des noch fehlenden Standards der Zuordnung einer CAN-Busleitung zu den Polen einer Anhängersteckdose ist es von Vorteil, wenn die elektrische Schaltung dasselbe Kommunikationssignal an mehrer Pole des Steckers ausgibt, vorzugsweise an alle, die für die Belegung als CAN-Busleitung überhaupt in Frage kommen.

Die neue Vorrichtung ist primär als Prüfvorrichtung vorgesehen, wobei die elektrische Schaltung beim Anlegen der Spannung an den jeweiligen Pol des Steckers ein Anzeigesignal an eine Anzeigeeinheit sendet, das auf das mit der Spannung bei korrekter Kontaktierung der Anhängerdose angesteuerte Leuchtmittel hinweist. So kann die Anzeige die Beleuchtung an der Rückseite eines Kraftfahrzeugs im Miniaturformat wiedergeben, wobei dann jeweils Leuchtdioden im Bereich des Leuchtmittels in der Anzeige aufleuchten, das über den Stecker angesteuert wird.

In einer besonders bevorzugten Ausführungsform der Vorrichtung als Prüfvorrichtung wird das Anzeigesignal als drahtloses Signal an eine entfernte Anzeigeeinheit übertragen. D. h., die Prüfvorrichtung besteht aus dem Stecker und der elektrischen Schaltung in einem Gehäuse und der davon getrennten Anzeigeeinheit, die drahtlose Signale von der elektrischen Schaltung empfängt.

Die neue Vorrichtung kann aber auch den Pol, an dem die Spannung anliegt, zusätzlich gepulst mit einem Ausgang verbinden, um an diesem eine gegenüber der Spannung reduzierte Ausgangsspannung bereitzustellen. Diese Ausgangsspannung kann nicht nur zum Betreiben irgendwelcher Anzeige-LEDs verwendet werden. So kann der Ausgang mit einem Pol einer Steckdose verdrahtet sein, über die dann ein mit LED-Leuchten ausgestatteter Anhänger angeschlossen werden kann, ohne dass auf diesem Anhänger noch eine Spannungsreduktion für den Betrieb der LED-Leuchten erfolgen muss. Die Vorrichtung dient dann als Adapter. Der Ausgang, mit dem der Pol zusätzlich gepulst verbunden wird, kann auch direkt an eine LED-Leuchte angeschlossen sein. Die Vorrichtung stellt dann weniger einen Adapter zwischen dem Kraftfahrzeug und dem Anhänger als vielmehr einen Teil des Anhängers oder einer an ein Kraftfahrzeug anzubauenden Einheit ohne eigenes Fahrwerk, wie beispielsweise eines Fahrradträgers, dar.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

### KURZBESCHREIBUNG DER FIGUREN

Die Erfindung wird im Folgenden anhand von drei in den angehängten Figuren schematisch dargestellten Ausführungsformen näher erläutert und beschrieben.
- **Fig. 1**: zeigt eine Prüfvorrichtung für das Überprüfen der korrekten Verdrahtung einer Anhängersteckdose.
- **Fig. 2**: zeigt eine Adaptervorrichtung zur Anordnung zwischen der Elektrik eines Kraftfahrzeugs und der Elektrik eines Anhängers; und
- **Fig. 3**: zeigt eine Beleuchtungsvorrichtung eines Fahrradträgers zum Anbau an ein Kraftfahrzeug.

### FIGURENBESCHREIBUNG

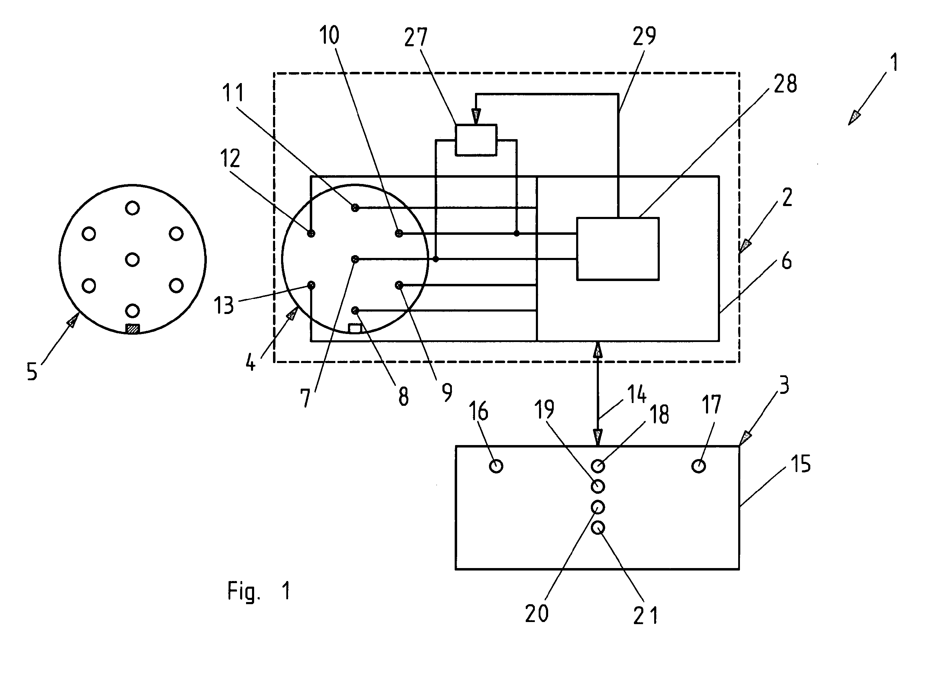

Die in Fig. 1 skizzierte Prüfvorrichtung 1 weist zwei Bestandteile 2 und 3 auf. Der Bestandteil 2 umfasst einen Stecker 4, der auf eine Anhängersteckdose 5 eines Kraftfahrzeugs abgestimmt ist. Die Anhängersteckdose 5 selbst gehört nicht zu der Prüfvorrichtung 1. Die Anhängersteckdose 5 kann, wie hier dargestellt ist, 7-polig sein. Sie kann auch 13-polig sein oder eine andere Polanzahl aufweisen. In jedem Fall ist sie vielpolig. Auf die genaue Anzahl ihrer Pole kommt es für die vorliegende Erfindung nicht an. Abhängig von der Anzahl der Pole kann es jedoch sinnvoll sein, eine elektrische Schaltung 6, die neben dem Stecker 4 zu dem Bestandteil 2 der Prüfvorrichtung 1 gehört, mit einer eigenen permanenten Stromversorgung in Form einer Batterie oder dgl. zu versehen. Die elektrische Schaltung 6 ist mit den Polen 7 bis 13 des Steckers 4 verdrahtet. Dabei ist dem Pol 7 hier die Funktion eines permanenten Minusleiters zugeordnet. Wenn über die Anhängersteckdose 5 an einen der anderen Pole 8 bis 13 eine Spannung angelegt wird, wird damit typischerweise eine Last in Form eines als Glühbirne ausgebildeten Leuchtmittels auf einem Anhänger, der an das jeweilige Kraftfahrzeug angehängt ist, angesteuert. Von dem Pol fließt daher im Betrieb des Anhängers ein gewisser Strom ab, der der Leistungsaufnahme der jeweiligen Last entspricht. Ein solcher Stromabfluss von dem jeweiligen Pol findet außer beim Pol 10 bei der Prüfvorrichtung 1 nicht statt. Stattdessen steuert ein Mikroprozessor 28 der elektrischen Schaltung 6 einen spannungsabhängigen Widerstand der fest mit dem Pol 10 und dem Pol 7 verdrahtet ist, in Abhängigkeit von den Spannungen an den anderen Polen mit unterschiedlichen Steuerspannungen 29 an. Dabei versteht sich, dass der Pol 10 entweder ein Dauerpluspol ist, oder wie hier bei einem 7-poligen Stecker durch Anlegen einer Dauerspannung, beispielsweise durch Anschalten des Fahrtlichts freigeschaltet werden muss. Im letztgenannten Fall muss der Widerstand 27 andauernd auch die Leistungsaufnahme der Rückleuchten des Fahrtlichts simulieren. Aufgrund der Steuerspannungen 29 fließt von dem Pol 10 über den Widerstand 27 zu dem Pol 7 ein Strom, der der Leistungsaufnahme der mit dem Pol 10 und den anderen Polen angesteuerten Lasten und damit den vom Kraftfahrzeug erwarteten Last entspricht. Dies gilt auch bei getakteten Spannungen an den anderen Polen, mit denen Blinker angesteuert werden. Das Kraftfahrzeug unterscheidet nicht, von welchem Pol der Strom abfließt und geht entsprechend von einer ordnungsgemäß Leistung aufnehmenden Last aus. Gleichzeitig übermittelt die elektrische Schaltung 6 ein Anzeigesignal 14, das hier ein drahtloses Signal ist, an eine Anzeigeeinheit 15, die den zweiten Bestandteil 3 der Prüfvorrichtung 1 darstellt. Die Anzeigeeinheit 15 weist Anzeigeleuchten 16 bis 21 auf, die den verschiedenen Leuchten an der Rückseite eines Kraftfahrzeugs bzw. eines Anhängers entsprechen. Wenn an einen der Pole 8 bis 13 eine Spannung angelegt wird, die beispielsweise dem Blinken des rechten Blinkers entspricht, führt das Anzeigesignal 14 dazu, dass die Anzeigeleuchte 17 leuchtet. In der Verwendung nimmt der Benutzer die Anzeigeeinheit 15 mit auf den Fahrersitz des jeweiligen Kraftfahrzeugs und betätigt bei in die Anhängersteckdose des Kraftfahrzeugs eingestecktem Stecker 4 beispielsweise den rechten Blinker des Kraftfahrzeugs. Bei korrekter Verdrahtung der Anhängersteckdose 5 leuchtet dann die Anzeigeleuchte 17 auf. Anderenfalls leuchtet eine der anderen Anzeigeleuchten 16 bzw. 18 bis 21 oder keine der Anzeigeleuchten 16 bis 21. Die Anzeigeleuchten 16 bis 21 werden von einer Batterie gespeist, die in der Anzeigeeinheit 115 zusammen mit einem Empfänger für das Anzeigesignal 14 und einer Elektronik für dessen Aufbereitung vorgesehen ist. Eine weitere, hier nicht dargestellte Anzeigeleuchte kann die korrekte Funktion der Anzeigeeinheit 15 und der elektrischen Schaltung 6 signalisieren.

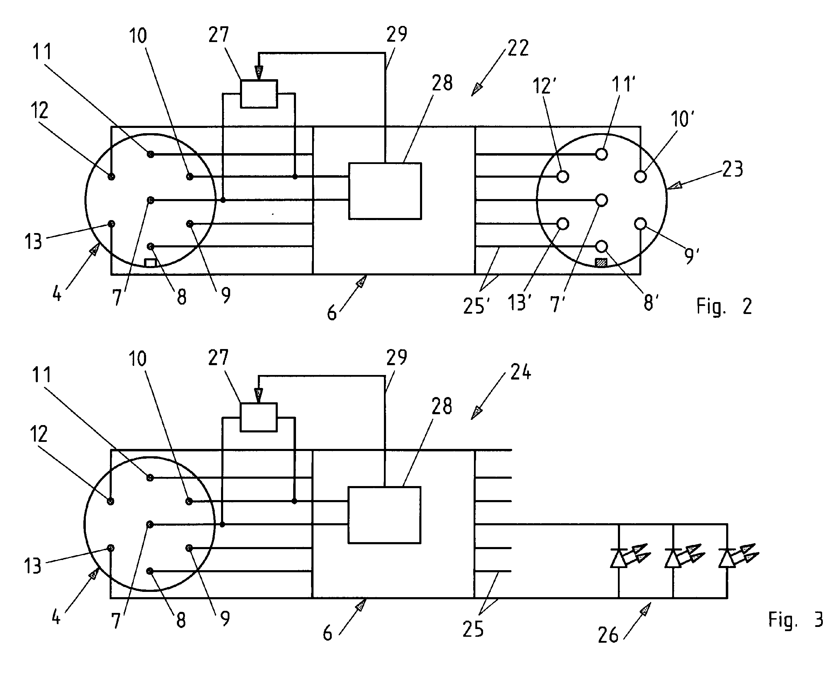

Die Adaptervorrichtung 22 gemäß Fig. 2 ist einteilig. Bei ihr steuert die elektrische Schaltung 6 beim Anliegen einer Spannung an den einzelnen Pole 8 bis 13 nicht nur den Widerstand 27 an, sondern schaltet diese Pole auch gepulst zu den entsprechenden Polen 8' bis 13' einer Steckdose 23 durch. Die elektrische Schaltung 6 simuliert damit nicht nur Lasten an den Polen 8 bis 13, sondern stellt über die Steckdose 23 auch reduzierte Spannungen bereit, um beispielsweise LED-Leuchten mit im Vergleich zu Glühbirnen nur geringer Nennspannung und Leistungsaufnahme auch ohne Vorschaltwiderstände auf einem Anhänger betreiben zu können.

Die Beleuchtungsvorrichtung 24 gemäß Fig. 3 weist anstelle einer Steckdose 23 fest mit den Ausgängen 25 der elektrischen Schaltung 6 verbundene LED-Leuchten 26 auf, von denen hier nur eine dargestellt ist. Die Beleuchtungsvorrichtung 24 ist beispielsweise für einen fest an ein Kraftfahrzeug anbaubaren Fahrradträger mit LED-Beleuchtung vorgesehen. Die elektrische Vorrichtung 6 betreibt die LED-Leuchten 26 mit gegenüber der Spannung an den Polen 8 bis 13 reduzierter Spannung und simuliert gleichzeitig für das jeweilige Kraftfahrzeug eine Leistungsaufnahme der Beleuchtung, die herkömmlichen Glühbirnen entspricht.

### BEZUGSZEICHENLISTE

- 1: Prüfvorrichtung
- 2: Bestandteil
- 3: Bestandteil
- 4: Stecker
- 5: Anhängersteckdose
- 6: elektrische Schaltung
- 7: Pol
- 8: Pol
- 9: Pol
- 10: Pol
- 11: Pol
- 12: Pol
- 13: Pol
- 14: Anzeigesignal
- 15: Anzeigeeinheit
- 16: Anzeigeleuchte
- 17: Anzeigeleuchte
- 18: Anzeigeleuchte
- 19: Anzeigeleuchte
- 20: Anzeigeleuchte
- 21: Anzeigeleuchte
- 22: Adaptervorrichtung
- 23: Steckdose
- 24: Beleuchtungsvorrichtung
- 25: Ausgang
- 26: LED-Leuchte
- 27: spannungsabhängiger Widerstand
- 28: Mikroprozessor
- 29: Steuerspannung

## Patentansprüche

1. Vorrichtung zum Anschluss an eine Anhängersteckdose eines Kraftfahrzeugs, mit einem vielpoligen Stecker und mit einer elektrischen Schaltung, die beim Anlegen einer Spannung an jeweils einen Pol des Steckers eine mit der Spannung an dem jeweiligen Pol ordnungsgemäß betriebene Last, insbesondere ein leuchtendes Leuchtmittel, simuliert, **dadurch gekennzeichnet, dass** die elektrische Schaltung (6) einen spannungsabhängigen Widerstand (27) zwischen zwei festen Polen (7 und 10) des Steckers (4) aufweist, der in Abhängigkeit von der Spannung an jeweils einem oder mehreren von verschiedenen anderen Polen (8, 9, 11-13) des Steckers (4) angesteuert wird.

2. Vorrichtung nach Anspruch 1, **dadurch gekennzeichnet, dass** der spannungsabhängige Widerstand (27) ein Halbleiterwiderstand, vorzugsweise ein Feldeffekttransistor, am meisten bevorzugt ein MOSFET (Metal Oxide Semiconductor Field Effect Transistor) ist.

3. Vorrichtung nach Anspruch 1 oder 2, **dadurch gekennzeichnet, dass** der spannungsabhängige Widerstand (27) thermisch mit einer Wärmesenke, insbesondere einem Kühlblech verbunden ist.

4. Vorrichtung nach einem der Ansprüche 1 bis 3, **dadurch gekennzeichnet, dass** die elektrische Schaltung (6) einen permanent mit Strom versorgten Mikroprozessor aufweist, der den spannungsabhängigen Widerstand (27) ansteuert.

5. Vorrichtung nach einem der Ansprüche 1 bis 4, **dadurch gekennzeichnet, dass** der spannungsabhängige Widerstand (27) bei einem 7-poligen Stecker zwischen einen Pol für Fahrtlicht und einen Pol für einen Minusleiter geschaltet ist.

6. Vorrichtung nach einem der Ansprüche 1 bis 4, **dadurch gekennzeichnet, dass** der spannungsabhängige Widerstand (27) bei einem 13-poligen Stecker zwischen einen Pol für Dauerplus und einen Pol für einen Minusleiter geschaltet ist.

7. Vorrichtung nach einem der Ansprüche 1 bis 6, **dadurch gekennzeichnet, dass** die elektrische Schaltung (6) beim Anlegen der Spannung an den jeweiligen Pol (8-13) des Steckers (4) an mindestens den gleichen oder einen anderen Pol (8-13) des Steckers (4) ein Kommunikationssignal ausgibt, das angibt, dass die Last in Ordnung ist.

8. Vorrichtung nach Anspruch 7, **dadurch gekennzeichnet, dass** das Kommunikationssignal auf eine an dem Pol (8-13) anliegende Spannung aufmoduliert wird.

9. Vorrichtung nach Anspruch 7 oder 8, **dadurch gekennzeichnet, dass** die elektrische Schaltung (6) dasselbe Kommunikationssignal an mehrere Pole (8-13) des Steckers (4) ausgibt.

10. Vorrichtung nach einem der Ansprüche 1 bis 9, **dadurch gekennzeichnet, dass** die elektrische Schaltung (6) beim Anlegen der Spannung an den jeweiligen Pol (8-13) des Steckers (4) ein Anzeigesignal (14) an eine Anzeigeeinheit (15) sendet, das auf das mit der Spannung bei korrekter Kontaktierung der Anhängersteckdose (5) angesteuerte Leuchtmittel hinweist.

11. Vorrichtung nach Anspruch 10, **dadurch gekennzeichnet, dass** das Anzeigesignal (14) ein drahtloses Signal an eine entfernte Anzeigeeinheit (15) ist.

## Claims

1. Device to be connected to a trailer outlet socket of a motor vehicle, the device comprising a multi contact plug and an electric circuitry which, upon application of a voltage at any one of the contacts of the plugs, simulates a load correctly operated with the voltage at the respective contact, particularly a luminous illuminant, **characterized in that** the electric circuitry (6) comprises a voltage-dependent resistor (27) between two fixed poles (7 and 10) of the plug (4), which is operated depending on the voltage at each one or more of different other contacts (8, 9, 11-13) of the plug.

2. The device of claim 1, **characterized in that** the voltage-dependent resistor (27) is a semiconductor resistor, preferably a field effect transistor, most preferably a MOSFET (Metal Oxide Semiconductor Field Effect Transistor).

3. The device of claim 1 or 2, **characterized in that** the voltage-depending resistor (27) is thermally connected to a heat sink, particularly a cooling plate.

4. The device of any of the claims 1 to 3, **characterized in that** the electric circuitry (6) comprises a micro processor permanently supplied with power which operates the voltage-depending resistor (27).

5. The device of any of the claims 1 to 4, **characterized in that** the voltage-dependent resistor (27), in a 7-contact plug, is connected between one contact for driving lights and one contact for a negative conductor.

6. The device of any of the claims 1 to 4, **characterized in that** the voltage-dependent resistor (27), in a 13-contact plug, is connected between one contact for permanent positive and one contact for a negative conductor.

7. The device of any of the claims 1 to 6, **characterized in that** the electric circuitry (6), upon application of the voltage to the respective contact (8-13) of the plug (4) issues a communication signal to at least the same or another contact (8-13) of the plug (4), which indicates that the load is in order.

8. The device of claim 7, **characterized in that** the communication signal is modulated upon a voltage applied to the contact (8-13).

9. The device of claim 7 or 8, **characterized in that** the electric circuitry (6) issues the same communication signal to several poles (8-13) of the plug (4).

10. The Device of any of the claims 1 to 9, **characterized in that** the electric circuitry (6), upon application of the voltage to the respective contact (8-13) of the plug (4), issues an indication signal (14) to an indication unit (15) which indicates the illuminant which is operated by the voltage with correct connection of the trailer outlet socket (5).

11. The device of claim 10, **characterized in that** the indication signal (14) is a wireless signal to a remote indication unit (15).

## Revendications

1. Dispositif de raccordement à une prise de courant d'une remorque d'un véhicule à moteur, comportant un connecteur à fiches multipolaire et comportant un circuit électrique qui, lors de l'application d'une tension sur respectivement un pôle du connecteur à fiches, simule une charge actionnée correctement avec la tension sur le pôle respectif, en particulier un moyen d'éclairage émettant de la lumière, **caractérisé en ce que** le circuit électrique (6) comporte une résistance (27), dépendant de la tension, entre deux pôles (7 et 10) fixes du connecteur à fiches (4), qui est actionnée en fonction de la tension sur respectivement un autre pôle ou plusieurs autres pôles (8, 9, 11-13) différents du connecteur à fiches (4).

2. Dispositif selon la revendication 1, **caractérisé en ce que** la résistance (27) dépendant de la tension est une résistance à semi-conducteur, de préférence un transistor à effet de champ, encore mieux un transistor à effet de champ à grille métal-oxyde (ou MOSFET pour Metal Oxide Semiconductor Field Effect Transistor).

3. Dispositif selon la revendication 1 ou 2, **caractérisé en ce que** la résistance (27) dépendant de la tension est reliée thermiquement à un dissipateur thermique, en particulier une tôle de refroidissement.

4. Dispositif selon l'une quelconque des revendications 1 à 3, **caractérisé en ce que** le circuit électrique (6) comporte un microprocesseur, qui est alimenté en permanence par un courant et qui commande la résistance (27) dépendant de la tension.

5. Dispositif selon l'une quelconque des revendications 1 à 4, **caractérisé en ce que** la résistance (27) dépendant de la tension, dans le cas d'un connecteur à fiches à sept pôles, est commutée entre un pôle pour un feu de route et un pôle pour un conducteur négatif.

6. Dispositif selon l'une quelconque des revendications 1 à 4, **caractérisé en ce que** la résistance (27) dépendant de la tension, dans le cas d'un connecteur à fiches à treize pôles, est commutée entre un pôle pour un positif permanent et un pôle pour un conducteur négatif.

7. Dispositif selon l'une quelconque des revendications 1 à 6, **caractérisé en ce que** le circuit électrique (6) qui, lors de l'application de la tension sur le pôle (8-13) respectif du connecteur à fiches (4), émet sur au moins le même pôle ou un autre pôle (8-13) du connecteur à fiches (4) un signal de communication, qui indique que la charge est correcte.

8. Dispositif selon la revendication 7, **caractérisé en ce que** le signal de communication est modulé à une tension appliquée sur le pôle (8-13).

9. Dispositif selon la revendication 7 ou 8, **caractérisé en ce que** le circuit électrique (6) émet le même signal de communication sur plusieurs pôles (8-13) du connecteur à fiches (4).

10. Dispositif selon l'une quelconque des revendications 1 à 9, **caractérisé en ce que** le circuit électrique (6), lors de l'application de la tension sur le pôle (8-13) respectif du connecteur à fiches (4), envoie un signal d'affichage (14) sur une unité d'affichage (15), qui indique le moyen d'éclairage activé par la tension lors de la mise en contact correcte de la prise de courant (5) de la remorque.

11. Dispositif selon la revendication 10, **caractérisé en ce que** le signal d'affichage (14) est un signal sans fil sur une unité d'affichage (15) éloignée.
